Europäisches Patentamt

European Patent Office

Office européen des brevets

(19)

(11) Veröffentlichungsnummer: **0 280 919**

**A2**

(12) **EUROPÄISCHE PATENTANMELDUNG**

(21) Anmeldenummer: **88101741.2**

(22) Anmeldetag: **06.02.88**

(51) Int. Cl.⁴: **H05K 13/00**

(30) Priorität: **25.02.87 IT 1948487**

(43) Veröffentlichungstag der Anmeldung:
**07.09.88 Patentblatt 88/36**

(84) Benannte Vertragsstaaten:
**DE ES FR GB IT SE**

(71) Anmelder: **Curti, Ezio**
**Strada Padana Superiore 57/59**
**I-20063 Cernusco sul Naviglio(IT)**

(72) Erfinder: **Curti, Ezio**
**Strada Padana Superiore 57/59**
**I-20063 Cernusco sul Naviglio(IT)**

(74) Vertreter: **Mayer, Hans Benno**
**Via dell'Orso 7/A**
**I-20121 Milano(IT)**

(54) **Verfahren und Vorrichtung zum Ausrichten einer Traegerplatte fuer gedruckte Schaltungen, gegenueber der Druckeinrichtung einer Maschine zum Bearbeiten von gedruckten Schaltungen.**

(57) Die Erfindung betrifft ein Verfahren und eine Vorrichtung zum Ausrichten einer Traegerplatte fuer gedruckte Schaltungen, gegenueber der Druckeinrichtung einer Maschine fuer die Erzeugung von gedruckten Schaltungen, unter Verwendung von Bezugsstiften die mit Bezugsbohrungen zusammenarbeiten, die in die Traegerplatte eingebracht sind. Die Bezugsachse von einem der Bezugsstifte ist oertlich gegenueber einem Arbeitstisch festgelegt, der verbleibende Bezugsstift ist beweglich angeordnet. Diese Bezugsstifte werden in bekannter Weise in Bezugsbohrungen eingebracht und anschliessend auseinandergesprizt, dabei wird der Verschiebeweg waehrend des Ausrichtvorganges der Achse des beweglichen Stiftes gemessen. Im Anschluss daran erfolgt ein Verstellen des Arbeitstisches um einen Wert, der der Haelfte der vorher gemessenen Verschiebebewegung entspricht, Verstellbewegung, die aber in entgegengesetzter Richtung erfolgt.

Die Vorrichtung weist hierzu einen verschiebbaren Wagen auf, der den Arbeitstisch aufnimmt und ueber einen, von einer zentralen Kontrolleinheit gesteuerten Motor, bewegbar und mit einer Messvorrichtung wirkverbunden ist, die die Laengsverschiebung des beweglich angeordneten Bezugsstiftes misst.

FIG. 5

**"Verfahren und Vorrichtung zum Ausrichten einer Traegerplatte fuer gedruckte Schaltungen, gegenueber der Druckeinrichtung einer Maschine zum Bearbeiten von gedruckten Schaltungen"**

Die vorstehende Erfindung betrifft ein Verfahren und eine Vorrichtung zum Ausrichten einer Traegerplatte fuer gedruckte Schaltungen, gegenueber der Druckeinrichtung einer Maschine zur Bearbeitung von gedruckten Schaltungen.

Bei der Herstellung von gedruckten Schaltungen, sowohl bei Verwendung der Siebdrucktechnik, als auch bei Verfahren mittels Fotobelichtung, ist es erforderlich, die Traegerplatte mit groesstmoeglicher Genauigkeit gegenueber dem fest angeordneten Bild der Druckvorrichtung auszurichten.

Zum Ausrichten einer Traegerplatte ist es bekannt, Bezugsstifte einzusetzen, die mit entsprechenden Bezugsbohrungen in der Traegerplatte fuer ein genaues Ausrichten der Platte zusammenwirken. Dieses Verfahren weist jedoch Nachteile auf, die besonders in einer fehlenden Praezision des Achsabstandes zwischen den Bohrungen der Traegerplatte und/oder den Abmessungen der Bohrungen zu suchen sind. Die auftretenden Ungenauigkeiten sind auf verschiedene Gruende zurueckzufuehren, wie z.B. Waermedehnung des Materials vor und waehrend des Bearbeitungsvorganges oder nicht vermeidbare Tolleranzabweichungen bei der Herstellung der Bezugsbohrungen.

In der italienischen Patentanmeldung 19514 A/85 des Anmelders wurde zur Vermeidung der Nachteile des Standes der Technik vorgeschlagen, spreizbare Bezugsstifte zu verwenden, die in geschlossenem Zustand einen Durchmesser aufweisen, der wesentlich kleiner als der Durchmesser der Bezugsbohrungen der Platte ist. Dadurch wird es moeglich, die geschlossenen Bezugsstifte leicht in die entsprechenden Bohrungen einzufuehren und einen Zentriervorgang auch beim Auftreten groessere Massabweichungen und/oder Tolleranzabweichungen durchzufuehren.

Mit Zunahme der Verzweigungen des zu uebertragenden Layout-Bildes fuer gedruckte Schaltungen und mit Abnahme der Breite der elektrischen Leiterspuren, hat es sich als immer - schwieriger erwiesen, das Bild des Siebdruckrahmens oder des Negativs registergenau gegenueber der Traegerplatte der gedruckten Schaltung auszurichten, auch wenn die Platte Bezugspunkte aufweist, z.B. in Form von Bohrungen, Einkerbungen und aehnlichem. Die Lage der Bezugsbohrungen in der Traegerplatte kann sich aufgrund von Waermedehnungen des Materials oder aufgrund ungenauer Ausfuehrung der Bezugsbohrungen haeufig aendern.

Auch wenn ein genaues Ausrichten der Traegerplatte gegenueber den Bezugsstiften moeglich sein sollte, bleibt immer die Gefahr, dass der Abdruck des Bildes fuer den elektronischen Schaltkreis stark zu einer Seite der Taergerplatte hin verschoben ist, dies fuehrt z.B. zu einem teilweisen Austreten der im Randbereich vorgesehenen Leiterspuren aus der Platte.

Aufgabe der vorstehenden Erfindung ist es, eine Moeglichkeit fuer ein sehr genaues Ausrichten der Traegerplatte gegenueber der Druckvorrichtung zu schaffen und besonders ein genaues Ausrichten der Koordinaten der Traegerplatte gegenueber den Koordinaten des Siebdruckrahmens oder des Negativs fuer die fotomechanische Uebertragung zu ermoeglichen, dies auch beim Einsatz von Traegerplatten, bei denen sich der Abstand zwischen zwei Bezugsbohrungen aendert, auch wenn die Traegerplatten der gleichen Serie entstammen.

In vorteilhafter Weise sollen die Achsen der Taegerplatte mit den Achsen, z.B. eines Siebdruckrahmens, zur Deckung gebracht werden. Erfindungsgemaess wird die Loesung mit einem Verfahren erzielt, das folgende Merkmale aufweist:

a) Ausrichten der Traegerplatte unter Verwendung spreizbarer Bezugsstifte, von denen ein Stift ortsfest und der andere Bezugsstift verschiebbar angeordnet sind;

b) Auseinandernspreizen der Bezugsstifte und Messung des eintretenden Verschiebeweges des beweglich angeordneten Bezugsstiftes mittels einer Messvorrichtung und Bildung eines entsprechenden elektrischen Signals mit positivem oder negativem Wert ( + ; -)

c) Bildung eines Signalwertes entsprechend der Richtung und der Groesse der gemessenen Verschiebebewegung, die durch den beweglichen Stift durchgefuehrt wird;

d) Verschieben des Auflagetisches fuer die Leiterplatte um einen Wert, der der Haelfte der gemessenen Verschiebebewegung des verfahrbaren Bezugsstiftes entspricht und in entgegengesetzter Richtung zum Verschiebehub des beweglichen Bezugsstiftes erfolgt;

e) Bearbeitung und Entnahme der Traegerplatte;

f) Zurueckfahren des beweglichen Bezugsstiftes in eine Bezugsstellung "Null".

Die Erfindung betrifft ferner eine Vorrichtung zum Ausrichen einer Traegerplatte fuer gedruckte Schaltungen gegenueber der Druckvorrichtung in einer Maschine zum Bearbeiten von Traegerplatten fuer gedruckte Schaltungen, mit einem Auflagetisch, von dem auseinderspreizbare Bezugsstifte abstehen, die mit entsprechenden Bezugsbohrungen in der Traegerplatte verbindbar sind, die groesseren Durchmesser als die geschlossenen Bezugsstifte haben und sich dadurch kennzeichnet, dass der Arbeitstisch verschiebbar auf Fuehrungen gelagert ist, die von zwei Supporten aufgenommen werden, die am Gestell der Maschine angeordnet sind, dass die Fuehrungen die Halterungen der auseinanderspreizbaren Bezugsstifte aufnehmen, wobei eine Halterung fest und eine laengsbeweglich gegenueber den Fuehrungsschienen angeordnet ist, dass eine Messvorrichtung zum Feststellen des Verschiebeweges des beweglichen Bezugsstiftes vorgesehen ist, und diese Vorrichtung mit einer programmierbaren Rechenvorrichtung wirkverbunden deren Signalausgang mit einem steuerbaren Antriebsmotor zum Verfahren des Arbeitstisches laengs der Fuehrungsschiene wirkverbunden ist. Mit einem Verfahren und einer Vorrichtung dieser Art werden Registerfehler beseitigt oder sehr klein gehalten, da eventuell auftretende Registerfehler gleichmaessig ueber die gesamte Leiterplatte verteilt werden.

Die Erfindung wird nun anhand eines Ausfuehrungsbeispieles beschrieben und in den Zeichnungen dargestellt.

Es zeigen:

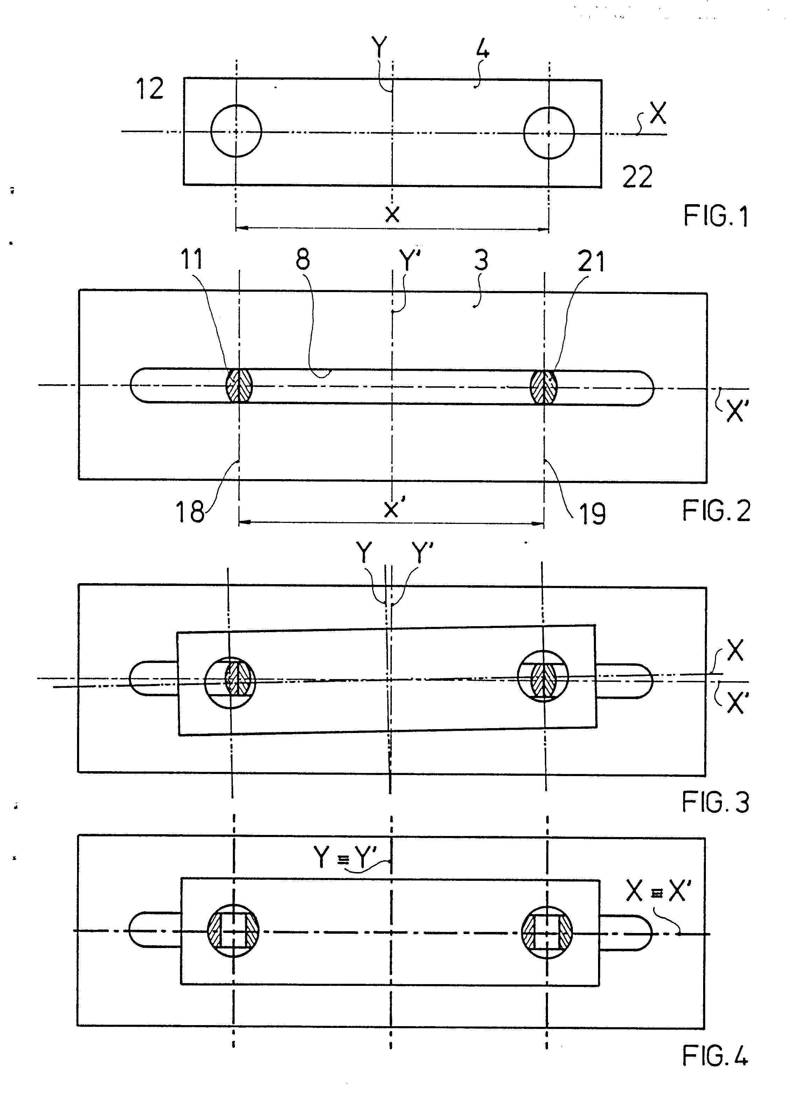

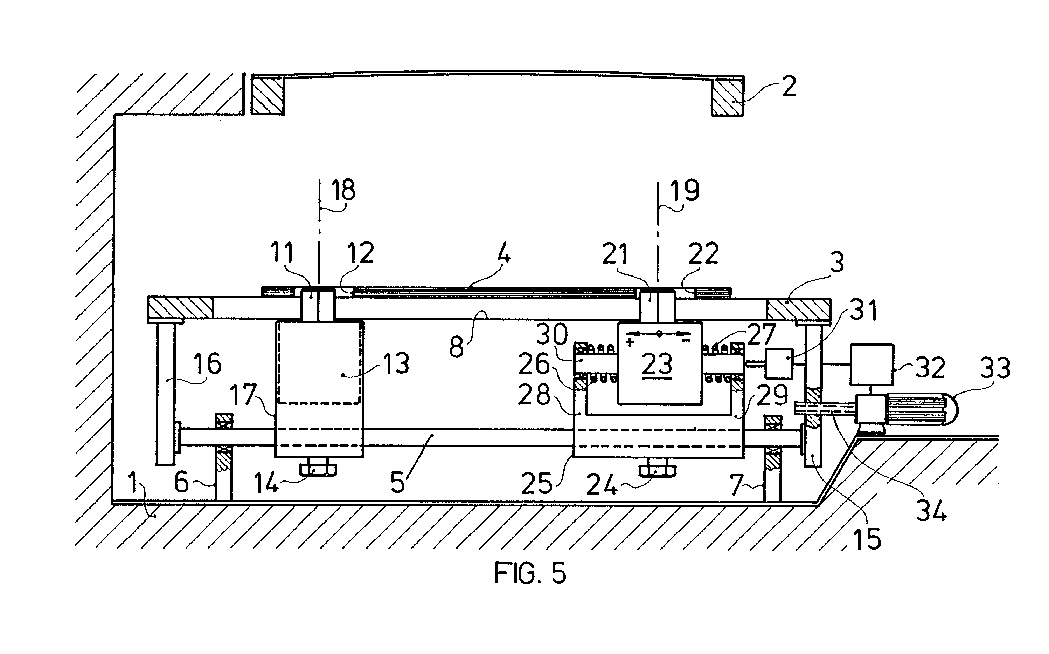

Die Figuren 1-4 schematisch das erfindungsgemaesse Verfahren; und Fig. 5 eine Schnittdarstellung der erfindungsgemaessen Vorrichtung.

Das Verfahren wird nun unter Bezugnahme auf die Figuren 1 - 4 fuer eine Platte 4 zur Aufnahme eines gedruckten Schaltkreises unter Vorsehung von zwei Bezugsbohrungen 12 und 22, die gleichen Durchmesser aufweisen, beschrieben.

Mit x ist der Achsabstand zwischen den Bohrungen 12 und 22 bezeichnet. Der Durchmesser der einzelnen Bohrungen 12 und 22 kann erhebliche Tolleranzen aufweisen.

Mit Y ist die Mittenachse senkrecht zur Achse X gekennzeichnet. Die Achse Y deckt sich normalerweise mit der Achse der Leiterplatte 4. Fig. 2 zeigt schematisch eine Draufsicht des Arbeitstisches 3, z.B. einer Siebdruckmaschine oder einer Maschine zum fotomechanischen Belichten der Traegerplatte 4. Der Tisch 3 weist ueblicherweise zwei auseinanderspreizbare Bezugsstifte 1 und 21 auf, die durch eine fensterartige Oeffnung 8 des Arbeitstisches 3 ragen. Die Platte 4 wird auf den Arbeitstisch 3 aufgelegt und ist fuer den Druckvorgang derartig auszurichten, dass die Mittenachse Y der Platte 4 mit der Projektion Y' der Mittenachse des Siebsdruckrahmens 2 oder des zu uebertragenden Negativs und die Achse X der Platte 4 mit der Achse X' des Siebdruckrahmens 2 uebereinstimmen.

Entsprechend dem erfindungsgemaessen Verfahren wird dies dadurch bewerkstelligt, dass die Achse 18 des Bezugsstifes 11 fest gegenueber dem Arbeitstisch 3 vorgesehen wird und die zwei Bezugsstifte 11 und 21 in geschlossener Stellung in die Bezugsbohrungen 12 und 22 der Platte 4 eingefuehrt werden, wie dies in Fig. 3 dargestellt ist. Im Anschluss daran werden die Bezugsstifte 11 und 12 in bekannter Weise auseinandrgespreizt, solange bis die Stifte mit der Wandung der Bezugsbohrungen 12 und 22 in Wirkverbindung treten. Da die Achse 18 des Bezugsstiftes 11 ortsfest angeordnet ist, die Achse 19 des Bezugsstiftes 21 aber die Moeglichkeit hat, sich laengs der fensterartigen Oeffnung 8 zu bewegen, erfolgt bei Auseinanderspreizen der Stifte 11 und 21 eine Verschiebung des verfahrbaren Bezugsstifes 21 nach links (+) oder nach rechts (-), entprechend der Groesse der Abweichung der Sollwerte der Bohrungen 12 und 22. Die Groesse der Verschiebung der Achse 19 des Bezugsstiftes 21 wird gemessen und anschliessend wird der gesamte Arbeitstisch 3 mit der Traegerplatte 4 in entgegengesetzter Richtung um einen Betrag verschoben, der der Haelfte des gemessenen Verschiebeweges des Stiftes 21 entspricht, derart, dass die Achsen X und X', sowie Y und Y' zur Deckung gebracht werden.

Mit diesem Verfahren laesst sich ein automatisches, registergenaues Ausrichten in Laengsrichtung und in Querrichtung der Leiterplatte durchfuehren.

Mit anderen Worten, es kann auch vorkommen, dass die beiden Achsen X und X' koennten nicht deckungsgleich sind, wie dies in uebertriebener Weise in den Zeichnungen dargestellt ist. Die registergenaue Ausrichtung in senkrechter Richtung, erfolgt in diesem Fall automatisch ueber ein mechanisches Ausrichten, dsa beim Auseinanderspreizen der Bezugsstifte 11 und 21 eintritt.

In Fig. 5 ist die erfindungsgemaesse Vorrichtung dargestellt. Es wurden die gleichen Bezugszeichen fuer uebereinstimmende Bauteile entsprechend den Figuren 1 - 4 verwendet.

In Fig. 5 ist schematisch der Rahmen einer Maschine 1 fuer die Bearbeitung von Traegerplatten 4 zur Aufnahme von gedruckten Schaltungen dargestellt.

Die Maschine 1 weist einen Bearbeitungstisch 3 auf, der eine Laengsoeffnung 8 aufweist. Der Tisch 3 dient zur Aufnahme einer Traegerplatte 4, die mit einem elektrischen Schaltkreis zu bedrucken ist. Die zu bedruckende Platte 4 ist unter einer bekannten Druckvorrichtung 2 angeordnet. Die Druckvorrichtung 2 ist in bekannter Weise am Maschinenrahmen angebracht.

Die auseinanderspreizbaren Bezugsstifte 11 und 21 werden von blockartigen Haltevorrichtungen 13 und 23 aufgenommen. In bekannter Weise nehmen die vorrichtungen 13 und 23 Einrichtungen zum gesteuerten Auseinanderspreizen der Stifte 11 und 21 auf. Die Bezugsstifte 11 und 21 treten aus der Ebene des Arbeitstisches 3 hervor und sind mit Bezugsbohrungen 12 und 22 verbindbare, die in die Traegerplatte 4 eingearbeitet sind.

Der Arbeitstisch 3 ist ueber Stuetzen 15 und 16 mit den Enden von Fuehrungen 5 verbunden, die verschiebbar in Lagersupporten 6 und 7 angeordnet sind, die mit dem Rahmen der Maschine verbunden sind.

Die Aufnahmevorrichtung 13 des Bezugsstiftes 11 wird von einer Halterung 17 aufgenommen. Die Halterung 17 weist eine Bohrung auf, die von der Fuehrung 5 durchdrungen wird. Die Einrichtung 13 und die Halterung 17 ist mit Hilfe einer Feststellschraube 14 gegenueber der Fuehrungsschiene 5 einstellbar und festlegbar. Der Bezugsstift 21 ist zusammen mit seiner Haltevorrichtung 23 auf der Fuehrungsschiene 5 ueber eine Vorrichtung 25 montiert. Die Vorrichtung 25 besteht aus einem durchbohrten C-foermigen Haltekoerper, der ueber eine Stellschraube 24 gegenueber der Fuehrungsschiene 5 festlegbar ist. Die Vorrichtung 25 weist zwei Arme 28 und 29 auf, die eine weitere Fuehrung 30 aufnehmen, mit der die Vorrichtung 23 wirkverbunden ist. Die Fuehrung 30 ist verschiebbar in Lagerungen der Arme 28 und 29 gelagert. Somit kann die Einrichtung 23 und die Achse 14 des Bezugsstiftes 21 in Laengsrichtung ( +, -) verschoben werden.

In vorteilhafter Weise wird der Bezugsstift 21 in einer festgelegten Lage durch zwei sich gegenueberliegende Federn 26 und 27 gehalten. Die Federn 26 und 27 sind koaxial auf den Fuehrungen 30 angeordnet.

Wie bereits beschrieben, sind beide Bezugsstifte 11 und 21 einstellbar in einer fensterartigen Oeffnung 8 montiert. Dies ist erforderlich, da in den Leiterplatten 4 Bezugsbohrungen 12 und 22 angeordnet sind, die mit unterschiedlichem Achsabstand in die verschiedenen Leiterplatten 4 eingebracht werden koennen.

Es ist daher erforderlich, dass die Vorrichtungen 17 und 25 in der Oeffnung 8 laengsverschiebbar angeordnet sind, aber in vorbestimmten Stellungen ueber die Feststellschrauben 14 und 24 festlegbar sind, um sicher zu sein, dass bei geschlossener Stellung der Bezugsstifte 11 und 21, diese in die Bezugsbohrungen 12, 22 der Leiterplatte einbringbar sind. Dies ganz unabhaengig von der Plattengroesse oder dem Format der mit der gedruckten Schaltung zu versehenen Leiterplatte 4. Die Vorrichtung 13 ist in Arbeitsstellung fest gegenueber dem Arbeitstisch 3 angeordnet. Der Bezugsstift 11 kann durch eine bekannte Vorrichtung auseinandergespreizt werden, ohne dass sich dabei die Stellung der Stiftachse 18 veraendert.

Auch die Vorrichtung 25 ist auf der Fuehrungsschiene 5 ueber eine Stellschraube 24 festgelegt. Die Einrichtung 23 kann ueber die Fuehrung 30 eine Laengsbewegung in den Lagerungen der Arme 28 und 29 durchfuehren, wobei die Grundstellung sowie die Verschiebebewegung durch eine Messeinrichtung 31 erfasst werden.

Die Messeinrichtung kann z.B. von einem Sensor beliebiger Bauart, z.B. von einem Transduktor gebildet sein. Der Transduktor weist einen Ausgang fuer die, entsprechend der Verschiebebewegung, gebildeten elektrischen Signale auf. Es kann auch ein optisches Lineal Verwendung finden oder es koennen andere, geeignete Vorrichtung zur Messung des Verschiebeweges verwendet werden. Die Messeinrichtung 31, die z.B. aus einem Sensor zur Messung des Verschiebeweges besteht, kann mit einem Verstaerker fuer das Messsignal ausgeruestet sein, sofern dies erforderlich ist.

Die Messeinrichtung 31 ist mit einer Steuereinheit 32 wirkverbunden. Diese Steuereinheit 32 besteht z.B. aus einem Mikroprozessor, der auf einen steuerbaren Elektromotor 33 einwirkt. Die Welle 34 des Motors 33 weist ein Gewinde auf und steht ueber ein Gegengewinde mit der Stuetze 15 des Tisches in Wirkverbindung. Somit, bei gesteuerter Drehbewegung der Welle 34 des Motors 33, erfolgt eine Laengsverschiebung in einer von zwei moeglichen Richtungen des Arbeitstisches 3 und der Fuehrungsschienen 5. In vorteilhafter Weise weist die Steuereinheit 33 bekannte elektronische mittel zum Ansteuern des Motors 33 auf.

Die Arbeitsweise der Vorrichtung ist folgende:

Die Bezugsstifte 11 und 21 werden in geschlossener Stellung in die Bezugsbohrungen 12 und 22 einer Traegerplatte 4 eingebracht. Anschliessend werden die Bezugsstifte 11 und 21 auseinandergespreizt, soweit wie dies der Durchmesser der Bezugsbohrungen 12, 22 der Traegerplatte 4 erlaubt. Die Bohrung 12 wird automatisch gegenueber dem Bezugsstift 11 zentriert, der die Lage seiner Achse 18 fest beibehaelt. Beim Auseinanderspreizen des Bezugsstiftes 21 erfolgt analog ein Zentrieren des Stiftes 21 gegenueber der Bezugsbohrung 22 was gleichzeitig eine Verschiebung nach links ( +) oder nach rechts (-), entsprechend der Differenz zum Achsabstand x mit sich bringt.

Durch die Messvorrichtung 31 wird die eintretende Verschiebung ueber die Fuehrung 30 gemessen und dieser Wert wird durch ein entsprechendes elektrisches Signal an die Steuer-und Recheneinheit 32 weitergeleitet. Die Recheneinheit 32 erstellt ein Korrektursignal entsprechend dem Wert, mit dem der Arbeitstisch 3 und somit die zu bedruckende Platte 4 nach rechts oder nach links zu verschieben ist. Die Verschiebebewegung erfolgt durch Ansteuern des Motors 33, der am Gestell 1 oder Maschine befestigt ist. Durch die Praezisionsgewindespindel 34 wird die gewuenschte Verschiebebewegung des Arbeitstisches 3 sowie der Traegerplatte 4 vorgenommen. Wenn durch eine zu bedruckende Platte 4 eine Verschiebung (D) durch die Messvorrichtung 31 festgestellt wird, so wird durch die Steuereinheit 32 ein Steuersignal gebildet, das dann eine Verschiebung der Platte 4 (in entgegengesetzter Richtung) um den Betrag (D/2) bewirkt, diese durch Verschieben des Arbeitstisches 3, ueber die Spindel 34 und den Motor 33 und der Bezugsstifte 11 und 21. Somit erfolgt eine registergenaue Verschiebung der Achse 18 des fest angeordneten Bezugsstiftes 11.

Nach Durchfuehrung des Druckvorganges erfolgt ein Zurueckfahren des Arbeitstisches 3 in eine Bezugsstellung "Null", die Vorrichtung ist nunmehr erneut in der Lage, einen Ausrichtvorgang fuer die naechste zu bedruckende Traegerplatte 4 vorzunehmen.

Ungenauigkeiten in der Deckung der Achsen (X) und (X') werden gewoehnlich aufgrund eines mechanischen Ausrichtvorganges beim Auseinanderspreizen der Bezugsstifte 11 und 21 beseitigt, sofern die Platte die annehmbaren Bearbeitungstoleranzen aufweist.

Das erfindungsgemaesse Verfahren und die dazugehoerige Vorrichtung sind auch auf Traegerplatten anwendbar, bei denen keine Bezugsbohrungen sondern Einfraesungen oder Ausstanzungen als Bezugspunkte dienen.

Zum Beispiel bei Vorsehung von 2 dreiecksfoermigen Ausnehmungen sind die Bezugsstifte mit entsprechender Form auszubilden, ferner ist die Moeglichkeit vorzusehen, dass ein Eintreten dieser Bezugsstifte in die seitlich angeordneten Ausstanzungen moeglich ist. Dabei ist ein Bezugsstift fest gegenueber dem Arbeitstisch 3 angeordnet und der zweite Bezugsstift wird z.B. solange verschoben, bis er mit der zugeordneten dreiecksfoermigen Ausstanzung in Wirkverbindung tritt. Diese Bewegung kann identisch mit einer vorgegebenen Bewegung sein, oder aber einen groesseren oder einen kleineren Wert annehmen.

Die festgestellte Differenz kann einen Wert darstellen, der dem genannten Verschiebewert D entspricht. Es ist somit erforderlich, den Arbeitstisch 3, sowie die Traegerplatte 4 um einen entsprechenden Korrekturwert D/2 in entgegengesetzter Richtung zu verfahren. In diesem Fall sind die Bezugsstifte in naheliegender Weise nicht auseinderspreizbar.

## Ansprüche

1. Verfahren, zum Ausrichten einer Traegerplatte (4) fuer gedruckte elektronische Schaltungen gegenueber der Druckeinrichtung einer Maschine zum Bearbeiten von gedruckten Schaltungen, wobei die Traegerplatte wenigstens zwei Bezugsbohrungen aufweist, mit denen auseinanderspreizbare Bezugsstifte, die aus der Ebene des Arbeitstisches der Maschine ragen, verbindbar sind, **dadurch gekennzeichnet,** dass folgende Verfahrensschritte vorgesehen sind:

a) Ausrichten der Traegerplatte (4) unter Verwendung auseinanderspreizbarer Bezugsstifte (11,12), wobei ein Bezugsstift (11) ortsfest und ein Bezugsstift (21) verschiebbar angeordnet ist;

b) Auseinanderspreizen der Bezugsstifte (11,21) und Messung des sich einstellenden Verschiebeweges des beweglich angeordneten Bezugsstiftes (21), mittels einer Messvorrichtung (31) und Bildung eines entsprechenden elektrischen Signales mit positivem oder negativem Wert ( +, -);

c) Bildung eines Signalwertes entsprechend der Richtung ( +, -) und der Groesse der gemessenen Verschiebebewegung, die durch den beweglichen Stift (21) durchgefuehrt wird;

d) Verschieben des Auflagetisches (3) fuer die Leiterplatte (4) um einen Wert, der der Haelfte der gemessenen Verschiebebewegung des verfahrbaren Bezugsstiftes (21) entspricht und in entgegengesetzter Richtung zum Veschiebungshub des bewegbaren Bezugsstifes (21) erfolgt;

e) Bearbeitung und Entnahme der Traegerplatte (4);

f) Zurueckfahren des verschiebbaren Bezugsstiftes (21) in eine Bezugstellung "Null".

2. Vorrichtung, zum Ausrichten einer Traegerplatte (4) fuer gedruckte Schaltungen gegenueber der Druckvorrichtung in einer Maschine zum Bearbeiten von gedruckten Schaltungen, mit einem Arbeitstisch (3), aus dessen Ebene auseinanderspreizbare Bezugsstifte ragen, die mit entsprechenden Bezugsbohrungen der Traegerplatte verbindbar sind, zur Durchfuehrung des Verfahrens nach Anspruch 1, **dadurch gekennzeichnet,** dass der Arbeitstisch (3) verschiebbar auf Fuehrungen (5) angeordnet ist, die von zwei Supporten (15,16) aufgenommen werden, die am Gestell der Maschine (1) angeordnet sind, dass die Fuehrungen (5) Halterungen (17,25) fuer auseinanderspreizbare Bezugsstifte (11,21) aufnehmen, wobei eine Halterung (17) fest und eine Halterung (25) laengsverschiebbar gegenueber den Fuehrungen (5) angeordnet ist, dass eine Messeinrichtung (31) zum Feststellen des Verschiebehubes des beweglich angeordneten Bezugsstiftes (21,25) vorgesehen ist, und die Messeinrichtung (31) mit einer programmierbaren Recheneinheit (32) wirkverbunden ist, deren Signalausgang mit einem steuerbaren Antriebsmotor (33) zum Verfahren des Arbeitstisches (3) laengs der Fuehrungen (5) mit diesem in Wirkverbindung steht.

3. Vorrichtung, nach Patentanspruch 2, **dadurch gekennzeichnet,** dass der Arbeitstisch (3) eine fensterartige Oeffnung (8) aufweist, die von den Bezugsstiften (11,12) durchdrungen wird und, dass die Bezugsstifte (11,12) von Haltevorrichtungen (17,25) aufgenommen werden, die einstellbar (14,24) an den Fuehrungen (5) angeordnet sind.

4. Vorrichtung, nach Patentanspruch 3, **dadurch gekennzeichnet,** dass die Haltevorrichtung (17) des Bezugsstiftes (11) in Arbeitstellung gegenueber den Fuehrungen (5) durch Vorsehen einer Stellschraube (14) und eines durchgehenden Gewindeloches in ihre Lage festlegbar ist.

5. Vorrichtung, nach Patentanspruch 4, **dadurch gekennzeichnet,** dass die Halterung (25) des verschiebbaren Fuehrungsstiftes (21) eine Vorrichtung aufweist, die unter Verwendung einer Stellschraube (24) und einer durchgehenden Gewindebohrung in Arbeitstellung festlegbar ist, dass diese Halterung (25) aus zwei Haltearmen (28,29) besteht, zwischen denen eine verschiebbare Fuehrungsstange (30) gelagert ist und diese zusammen mit dem Bezugsstift (21) in einer bestimmten Bezugstellung (Null-Lage) unter Verwendung von Federmitteln (26,27) gehalten wird, die zwischen der Aufnahmevorrichtung (23) und den Armen (28,29) angeordnet sind.

6. Vorrichtung, nach Patentanspruch 5, **dadurch gekennzeichnet,** dass die Messvorrichtung (31) einen Taster aufweist, der zur Abnahme der Verschiebebewegung mit einem Ende der verschiebbaren Fuehrungsstange (30) in Wirkverbindung steht.

7. Vorrichtung, nach Patentanspruch 6, **dadurch gekennzeichnet,** dass die Welle des steuerbaren Antriebsmotores (33) als Gewindewelle (34) ausgebildet ist, die mit einer zugeordneten Gewindebohrung des Arbeitstisches (3,15) in Wirkverbindung steht.

FIG.1

FIG.2

FIG.3

FIG.4

FIG. 5